# EUROPÄISCHE PATENTANMELDUNG

(11) **EP 2 066 164 A2**
(43) Veröffentlichungstag der Anmeldung: **03.06.2009**
(21) Anmeldenummer: 08167541.5
(22) Anmeldetag: 24.10.2008
(51) Int. Cl.: H05K 7/20, G06F 1/20

(54) **Einschub für ein Serverrack sowie Anordnung mit einem Einschub und einer Kühlvorrichtung für ein Serverrack**

(30) Priorität: 27.11.2007 DE 102007056982
(71) Anmelder: Fujitsu Siemens Computers GmbH, 80807 München (DE)
(72) Erfinder: Scheidler, Gerold, 33181 Bad Wünnenberg (DE)
(74) Vertreter: Epping - Hermann - Fischer

(57) **Zusammenfassung**

Die Erfindung betrifft einen Einschub (1) für ein Serverrack (19) welcher Wärme erzeugende Einheiten (10) aufweist. Dabei weist der Einschub (1) an seiner Rückseite (2) zumindest ein Modul (6) mit einem Anschluss (9) zum Anschließen eines oder mehrerer Kühlluftschläuche (24) oder einen Luftzuführungsadapter (3) auf, wobei in den Luftzuführungsadapter (3) entweder ein Modul (6) mit einem Anschluss (9) zum Anschließen eines oder mehrerer Kühlluftschläuche (24) oder ein Lüftermodul (17) einsetzbar ist.

Die Erfindung betrifft weiterhin eine Anordnung mit dem genannten Einschub (1) und einer Kühlvorrichtung (28) welche eine Kühleinheit (22) aufweist und wobei an die Kühlvorrichtung (28) ein oder mehrere Kühlluftschläuche (24) angeschlossen sind, welche kühle Luft von der Kühleinheit (22) aus der Kühlvorrichtung (28) herausleiten können.

## Beschreibung

Die Erfindung betrifft einen Einschub für ein Serverrack, welcher Wärme erzeugende Einheiten aufweist.

Die Erfindung betrifft weiterhin eine Anordnung mit einem Einschub für ein Serverrack, welcher Wärme erzeugende Einheiten aufweist und einer Kühlvorrichtung, welche eine Kühleinheit aufweist.

In einem 19"-Serverrack werden Server als Einschübe vertikal übereinander angeordnet. Im jedem Einschub werden in der Regel Mittel zur Kühlung von Wärme erzeugenden Einheiten angeordnet. Dabei ist üblicherweise vorgesehen, dass jeder Einschub integrierte Lüfter aufweist. Durch die Lüfter wird Luft durch die Vorderseite des Einschubs angesaugt, kühlt beim Vorbeiströmen die elektronischen, Wärme erzeugenden Einheiten und wird an der Rückseite des Einschubs wieder ausgeblasen.

Beim Ausfall eines oder mehrerer Lüfter muss die Kühlung der Wärme erzeugenden Einheiten sichergestellt sein. Dazu sind in der Regel zusätzliche, redundante Lüfter in dem Einschub vorgesehen.

Nachteilig ist, dass die Lüfter viel Platz innerhalb eines Einschubs benötigen. Zudem muss die Vorderseite eines Einschubs einen Bereich für den Kühllufteinlass aufweisen.

Ein weiterer Nachteil ist, dass aufgrund der vorgegebenen kleinen Abmessungen die verwendeten Lüfter sehr ineffizient arbeiten. Sie erzeugen außerdem einen hohen Geräuschpegel.

Der Erfindung liegt die Aufgabe zugrunde, ein effizientes Kühlkonzept für Serverracks aufzuzeigen.

Die Aufgabe wird gelöst durch die Maßnahmen der unabhängigen Patentansprüche. Vorteilhafte Weiterbildungen sind Gegenstand der Unteransprüche.

Dementsprechend ist ein Einschub für ein Serverrack, welcher Wärme erzeugende Einheiten aufweist, vorgesehen, welcher zumindest ein Modul mit einem Anschluss zum Anschließen eines oder mehrerer Kühlluftschläuche an seiner Rückseite aufweist.

Im Vorderbereich des Einschubs werden keine Lüftungsöffnungen benötigt und es steht mehr Platz für Einbaukomponenten zur Verfügung. Die Lüfter sind aus dem Einschub herausgenommen. Innerhalb des Einschubs wird der Platz für Lüfter eingespart. Der Einschub kann damit kompakt und kostengünstig ohne Platzrestriktion an seiner Vorderseite mit Wärme erzeugenden Einheiten bestückt werden.

In einer Ausgestaltung weist der Einschub ein Kühlkanalsystem auf, wobei das Modul mit dem Kühlkanalsystem gekoppelt ist und der oder die Kühlkanäle des Systems Kühlluft zu den Wärme erzeugenden Einheiten führen. Auf diese Weise entsteht eine wärmeübertragungsfähige Verbindung zwischen dem Modul und den Wärme erzeugenden Einheiten. Kühle Luft, welche durch den Anschluss von außen dem Gerät zugeführt wird kann mit Hilfe der Kühlkanäle den Wärme erzeugenden Einheiten direkt zugeführt werden.

In einer vorteilhaften Ausgestaltung wird die von den Wärme erzeugenden Einheiten erwärmte Luft über die Rückseite des Einschubs abgeführt. Dies kann mit Hilfe eines Kühlkanals oder eines Kühlkanalsystems erfolgen.

In einer vorteilhaften Ausgestaltung der Erfindung kann das Modul eine Drosselvorrichtung zur Einstellung des Luftdrucks der zugeführten Luft aufweisen. Über den Luftdruck kann die Kühlung eines Einschubs auf den Bedarf eingestellt werden.

In vorteilhaften Ausgestaltungen können Hotplug-fähige Einheiten, das heißt Einheiten, welche bei laufendem Betrieb des Serverracks angeschlossen werden können, über die komplette Vorderseite des Einschubs angeordnet werden.

Die Aufgabe wird weiterhin gelöst durch eine Anordnung mit einer Kühlvorrichtung, wobei die Kühlvorrichtung eine Kühleinheit aufweist, an welche ein oder mehrere Kühlluftschläuche angeschlossen sind, welche Kühlluft von der Kühleinheit aus der Kühlvorrichtung herausleiten können und einem Einschub für ein Serverrack, welcher ein Modul mit einem Anschluss zum Anschließen eines oder mehrerer Kühlluftschläuche an der Rückseite aufweist.

Die Anordnung kann weiterhin Kühlluftschläuche umfassen, welche sowohl an der Kühlvorrichtung als auch an den Einschub angeschlossen sind, wobei ein Anschluss der Kühlluftschläuche an die Geräte diese so verbindet, dass die Kühlvorrichtung kühle Luft durch die Kühlluftschläuche in den Einschub mit den Wärme erzeugenden Einheiten überführen kann. Die Kühlvorrichtung kann zu diesem Zweck eine Kühleinheit aufweisen, beispielsweise einen Wärmetauscher, sowie eine Strömungserzeugungseinheit, beispielsweise einen Lüfter.

Die Kühlvorrichtung kann als Kühleinschub ausgebildet sein, der in das Serverrack eingebaut werden kann.

In einem Serverrack, in welchem die Einschübe vertikal übereinander angeordnet sind, kann der Kühleinschub höher ausgebildet sein als der Einschub mit dem Modul an seiner Rückseite. Dadurch sind Lüfter einsetzbar, welche in ihrem Durchmesser größer sind als die Höhe des Einschubs mit dem Modul und den Wärme erzeugenden Einheiten. Größere Lüfter arbeiten effizienter und sparen dadurch Energie ein.

Die Aufgabe wird weiterhin gelöst durch eine Anordnung mit einem Serverrack, einer Kühlvorrichtung für das Serverrack, welche zumindest eine Kühleinheit aufweist, wobei an die Kühlvorrichtung ein oder mehrere Kühlluftschläuche angeschlossen sind und einem Einschub für das Serverrack, wobei der Einschub zumindest ein Modul mit einem Anschluss zum Anschließen eines oder mehrerer Kühlluftschläuche an der Rückseite aufweist.

Das Kühlkonzept betrifft in einer vorteilhaften Weiterbildung Serverfarmen und Rechenzentren. Die Kühlvorrichtung kann sowohl ein Serverrack als auch mehrere Serverracks mit Kühlluft versorgen. Dabei kann die Kühlvorrichtung in demselben Raum wie auch außerhalb des Raums, in welchem die Serverracks sind, angeordnet sein.

In vorteilhaften Ausgestaltungen weist die Kühleinheit eine Regelvorrichtung auf, mittels welcher die Temperatur der Luft, welche aus der Kühlvorrichtung herausgeleitet wird, einstellbar ist. Die Regelvorrichtung ist bevorzugt von der Außenseite der Kühlvorrichtung bedienbar.

Durch die Verwendung vorgekühlter Luft steht ein weiterer Regelungsparameter zur Verfügung. Die Kühlung kann durch die Strömungsgeschwindigkeit und durch die Temperatur der Luft geregelt werden.

Die Aufgabe wird weiterhin gelöst durch einen Einschub für ein Serverrack, welcher an seiner Rückseite zumindest einen Luftzuführungsadapter aufweist, sowie Wärme erzeugende Einheiten, wobei in dem Luftzuführungsadapter entweder ein Modul mit einem Anschluss zum Anschließen eines oder mehrerer Kühlluftschläuche oder alternativ ein Lüftermodul einsetzbar ist.

Wenn ein Lüftermodul in den Luftzuführungsadapter eingesetzt wird, ist der Einschub in einem Serverrack ohne externe Kühlvorrichtung einsetzbar. Ist eine externe Kühlvorrichtung, wie zum Beispiel ein Kühleinschub vorgesehen, wird ein Modul mit einem Anschluss zum Anschließen eines oder mehrerer Kühlluftschläuche in den Luftzuführungsadapter eingesetzt und die Wärme erzeugenden Einheiten des Einschubs können durch die externe Kühlvorrichtung gekühlt werden.

Weiterhin kann der Einschub ein Kühlkanalsystem aufweisen, welche den Luftzuführungsadapter mit den Wärme erzeugenden Einheiten verbindet.

In einer weiteren Ausgestaltung kann die von den Wärme erzeugenden Einheiten erwärmte Luft über ein weiteres Kühlkanalsystem dem Luftzuführungsadapter zugeführt und über die Rückseite wieder aus dem Gerät herausgeleitet werden.

Der Luftzuführungsadapter kann eine Drosselvorrichtung aufweisen, durch welche der Druck der zugeführten Luft einstellbar ist.

Weiterhin kann der Einschub über seine gesamte Vorderseite Hotplug-fähige Einheiten aufweisen.

Der Einschub kann durch Kühlluftschläuche mit einer Kühlvorrichtung verbunden werden, etwa einem Kühleinschub in einem Serverrack. Er kann in einem Serverrack angeordnet sein und durch Kühlluftschläuche mit einer Kühlvorrichtung verbunden sein, welche außerhalb des Serverracks angeordnet ist.

Nachfolgend werden weitere Vorteile der Erfindung anhand mehrerer Ausführungsbeispiele erläutert.

### Es zeigen:

- Figur 1: eine schematische Innenansicht eines Einschubs,
- Figur 2: eine weitere schematische Innenansicht eines Einschubs,
- Figur 3: eine schematische Perspektivansicht einer Anordnung mit einem Serverrack, zwei Einschüben und einem Kühleinschub und
- Figur 4: eine schematische Seitenansicht einer Anordnung mit einer Kühlvorrichtung und zwei Serverracks.

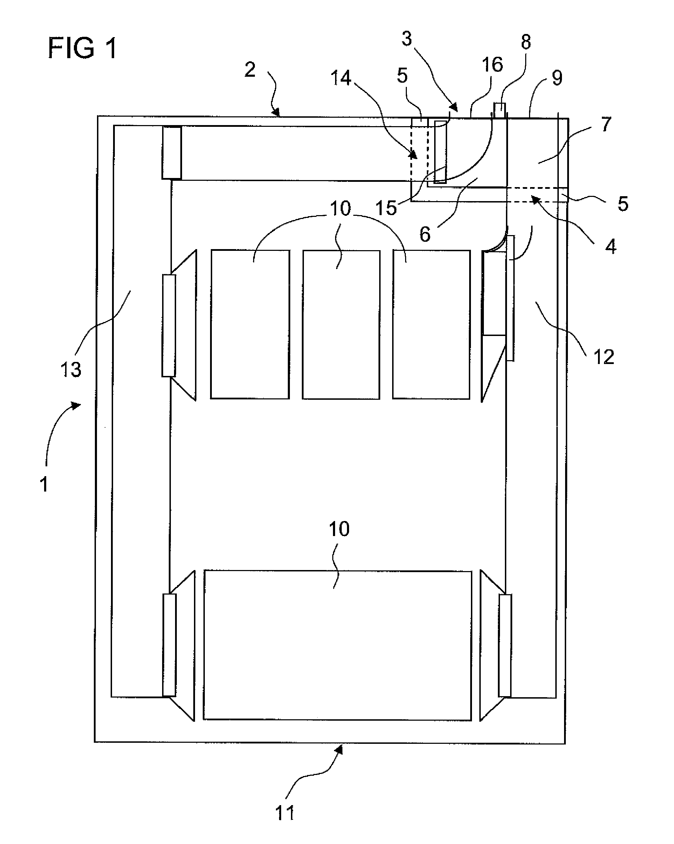

In Figur 1 ist ein Einschub 1 für ein Serverrack 19 dargestellt, wobei der Einschub 1 an seiner Rückseite 2 einen Luftzuführungsadapter 3 aufweist.

Der Luftzuführungsadapter 3 ist eine Vorrichtung, welche so ausgebildet ist, dass sie den Eintritt von Luft in den Einschub 1 ermöglicht. Er umfasst zumindest eine Öffnung 4, welche in den Einschub 1 weist. Der Luftzuführungsadapter 3 ist als rechteckige Aussparung an dem Rand der rechteckigen Grundfläche des Einschubs 1 ausgebildet und weist eine Höhe auf, welche sich über einen Teil oder den ganzen Einschub 1 erstreckt. Weiterhin weist er Befestigungsvorrichtungen 5 wie Rastelemente oder Schraubvorrichtungen auf, über die ein die quaderförmige Aussparung ausfüllendes Modul 6 an den Einschub 1 befestigt werden kann. Alternativ weist er Vorrichtungen zur Aufnahme von Bolzen auf mittels welcher das Modul 6 ebenfalls befestigt werden kann. Der Luftzuführungsadapter 3 ermöglicht und regelt den Eintritt von Luft durch die Öffnung 4, welche in den Einschub 1 führt. In dem Modul 6 ist ein Kühlkanal 7 ausgebildet, welcher ausgestaltet ist, mit der Öffnung 4 zusammenzuwirken. Das Modul 6 weist weiterhin eine Drosselvorrichtung 8 auf. Alternativ kann die Drosselvorrichtung 8 auch am Luftzuführungsadapter 3 angeordnet sein.

Das Modul 6 weist einen Anschluss 9 auf, der aus der Rückseite 2 des Einschubs 1 herausragt. An den Anschluss 9 kann ein Kühlluftschlauch 24 angeschlossen werden, um den Kühlluftschlauch 24 mit dem Kühlkanal 7 zu verbinden.

Der Einschub 1 weist mehrere Wärme erzeugende Einheiten 10 auf. An der Vorderseite 11 des Einschubs 1 wird auf Luftzuführungsöffnungen verzichtet. Die Wärme erzeugenden Einheiten 10 können somit an der kompletten Vorderseite 11 des Einschubs 1 angeordnet werden. An der Vorderseite 11 sind zum Beispiel Hotplug-fähige Einbaukomponenten wie CD-ROM-Laufwerke und Festplatte angeordnet.

Der Kühlkanal 7 ist über die Öffnung 4 an ein Kühlkanalsystem 12 angeschlossen. Der Kühlkanal 7 und das Kühlkanalsystem 12 sind beispielsweise als Luftleithaube aus Blech oder Plastik ausgebildet. Die Querschnitte der Austrittsöffnungen des Kühlkanalsystems 12 sind auf die Größe der Wärme erzeugenden Einheiten 10 abgestimmt.

Im Betrieb des Einschubs 1 in einem Serverrack 19 wird die Luft, welche sich an den Wärme erzeugenden Einheiten 10 erwärmt über ein weiteres Kühlkanalsystem 13 zur Rückseite 2 des Einschubs 1 geführt. Dort kann sie aus dem Einschub 1 austreten. Der Luftzuführungsadapter 3 weist zu diesem Zweck eine weitere Öffnung 14, welche in den Einschub 1 weist, auf. In dem Luftzuführungsadapter 3 ist ein Verbindungskanal 15 zwischen der weiteren Öffnung 14 und einem weiteren Anschluss 16 ausgebildet, so dass die erwärmte Luft aus dem weiteren Anschluss 16 austreten kann. An den weiteren Anschluss 16 kann ein Kühlluftschlauch 24 angeschlossen werden.

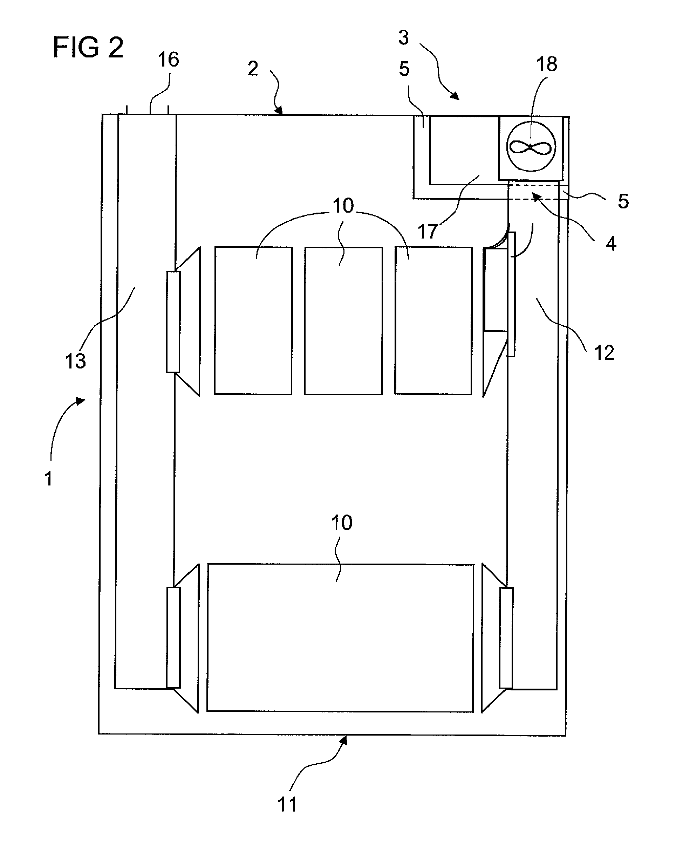

In Figur 2 ist eine alternative Ausführungsform dargestellt. In den Luftzuführungsadapter 3 ist ein Lüftermodul 17 eingesetzt. Das Kühlkanalsystem 12 und die Wärme erzeugenden Einheiten 10 sind analog dem in Figur 1 dargestellten Ausführungsbeispiel ausgebildet.

Das Lüftermodul 17 weist einen Lüfter 18 auf. Der Lüfter 18 saugt Luft von der Rückseite 2 des Einschubs 1 an und bläst diese über die Öffnung 4 in das Kühlkanalsystem 12. Hierbei muss die Umgebungsluft des Lüftermoduls 17 an der Rückseite 2 des Einschubs 1 ausreichend kalt sein. Deshalb ist der weitere Anschluss 16, aus dem die von den Wärme erzeugenden Einheiten 10 erwärmte Luft austritt, in diesem Ausführungsbeispiel auf der dem Lüftermodul 17 entgegen gesetzten Seite der Rückseite 2 des Einschubs 1 angeordnet.

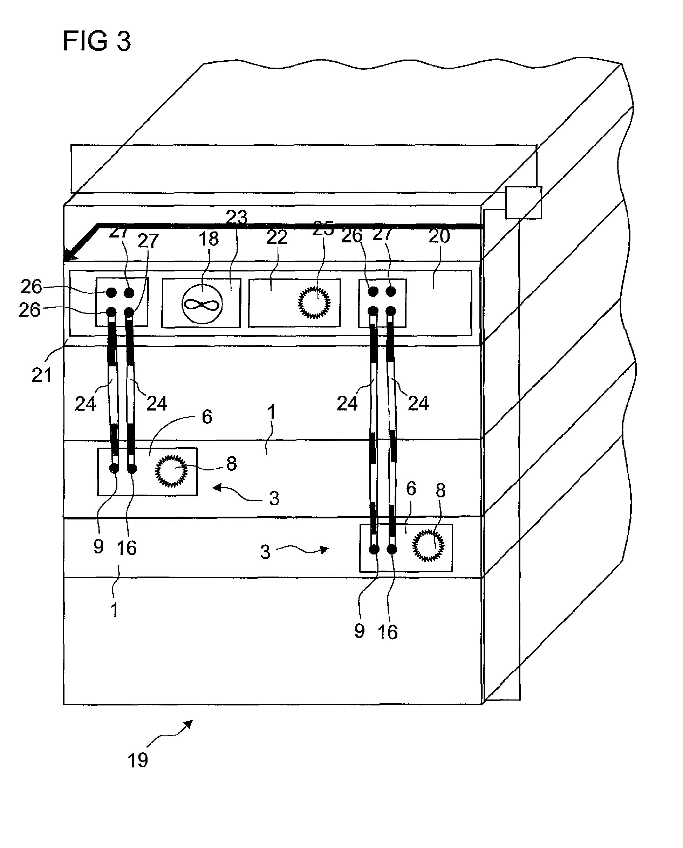

In Figur 3 ist als weiteres Ausführungsbeispiel ein Kühlkreislauf in einem Serverrack 19 schematisch dargestellt. Ein Kühleinschub 20 und zwei Einschübe 1 mit Wärme erzeugenden Einheiten 10 (nicht dargestellt) sind vertikal übereinander angeordnet. Der Kühleinschub 20 weist eine Schalldämmung 21 auf. Weiterhin weist der Kühleinschub 20 eine Kühleinheit 22 sowie eine Strömungserzeugungseinheit 23 auf. Die Einschübe 1 sind mit dem Kühleinschub 20 durch Kühlluftschläuche 24 verbunden. Die Einschübe 1 weisen je einen Luftzuführungsadapter 3 auf, in welchem Module 6 eingesetzt sind, die über die Kühlluftschläuche 24 an den Kühleinschub 20 gekoppelt sind. Die Module 6 weisen Drosselvorrichtungen 8 auf.

In der Kühleinheit 22 des Kühleinschubs 20 wird Luft vorgekühlt. Die Kühleinheit 22 ist beispielsweise als Wärmetauscher ausgebildet. Sie weist eine Regelvorrichtung 25 auf, mittels welcher die Temperatur der Luft, die zur Kühlung des oder der Einschübe 1 verwendet wird, eingestellt werden kann. Alternativ kann die Kühleinheit 22 als ein oder mehrere Lüfter 18 ausgebildet sein, wobei in diesem Fall die Strömungserzeugungseinheit 23 und die Kühleinheit 22 als eine Einheit ausgebildet sind. Die Regelvorrichtung 25 kann in dem Fall die Drehzahl der Lüfter 18 und damit die Strömungsgeschwindigkeit der Luft steuern.

Die Strömungserzeugungseinheit 23 überführt die vorgekühlte Luft an der Rückseite des Kühleinschubs 20 in die Kühlluftschläuche 24. Über die Kühlluftschläuche 24 wird die vorgekühlte Luft den Anschlüssen 9 der Einschübe 1 zugeführt.

Mit Hilfe der Drosselvorrichtungen 8 an den Einschüben 1 kann der Druck der zugeführten Luft eingestellt werden. Die Drosselvorrichtung 8 ist beispielsweise so ausgebildet, dass sie die Öffnung 4 im Luftzuführungsadapter 3 verjüngen kann und so den Durchfluss durch die Öffnung 4 regelt. Sie kann als Absperrhahn ausgebildet sein.

In dem dargestellten Ausführungsbeispiel weist der Kühleinschub 20 mehrere Ausströmöffnungen 26 und mehrere Einströmöffnungen 27 auf, an welche jeweils Kühlluftschläuche 24 angeschlossen werden können. Der Kühleinschub 20 ist somit als ein zentrales Versorgungselement ausgebildet, welches mehrere Einschübe 1 versorgen kann.

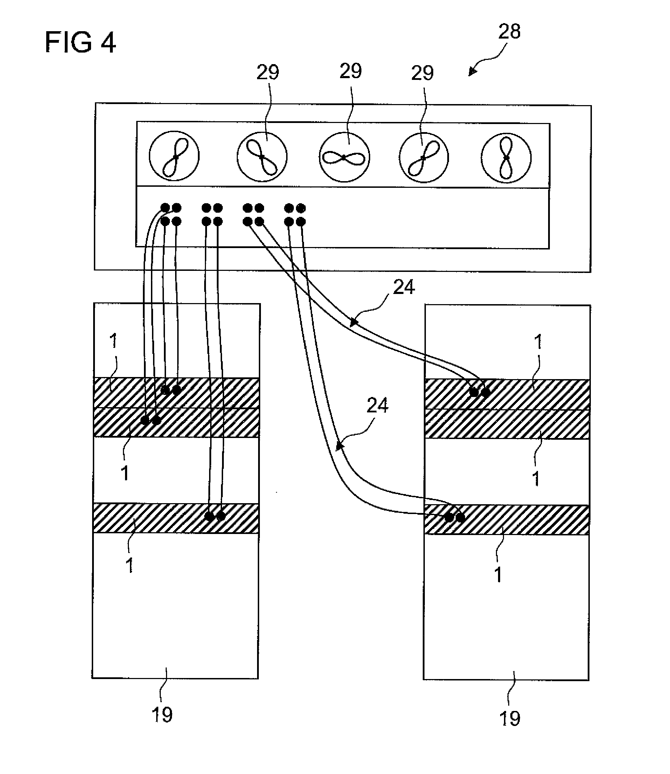

Figur 4 zeigt eine Anordnung mit zwei Serverracks 19 und einer externen Kühlvorrichtung 28. In der Kühlvorrichtung 20 werden zentrale Lüfter 29 zur Kühlung mehrerer Einschübe 1 (schraffiert dargestellt) verwendet, die mittels Kühlluftschläuchen 24 an die externe Kühlvorrichtung 28 gekoppelt sind. Nicht alle Einschübe 1 müssen dabei an die externe Kühlvorrichtung 28 gekoppelt sein.

Die Anordnung ist ein Kühlkonzept für ein Rechenzentrum oder auch eine Serverfarm und kann mehr als zwei Serverracks 19 umfassen. Die Abwärme wird in diesem Beispiel aus den einzelnen Einschüben 1 wieder herausgeführt und an die externe Kühlvorrichtung 28 abgeführt. Durch den Einsatz zentraler Lüfter 29 kann der Einsatz vieler kleiner Lüfter in den Einschüben 1 vermieden werden.

Die externe Kühlvorrichtung 28 kann in demselben Raum, sowie auch außerhalb des Raums, in welchem die Serverracks 19 sind, angeordnet sein. Die Kühlung wird dann nicht mehr durch die direkte Umgebungsluft der Einschübe 1 bewirkt.

Die externe Kühlvorrichtung 28 ist bevorzugt redundant ausgelegt. Bei dem Ausfall einer oder mehrerer Kühleinheiten 22 ist eine Kühlung aller angeschlossener Einschübe 1 dennoch sichergestellt.

Bezugszeichenliste
- 1: Einschub
- 2: Rückseite
- 3: Luftzuführungsadapter
- 4: Öffnung
- 5: Befestigungsvorrichtung
- 6: Modul
- 7: Kühlkanal
- 8: Drosselvorrichtung
- 9: Anschluss
- 10: Wärme erzeugende Einheiten
- 11: Vorderseite
- 12: Kühlkanalsystem
- 13: weiteres Kühlkanalsystem
- 14: weitere Öffnung
- 15: Verbindungskanal
- 16: weiterer Anschluss
- 17: Lüftermodul
- 18: Lüfter
- 19: Serverrack
- 20: Kühleinschub
- 21: Schalldämmung
- 22: Kühleinheit
- 23: Strömungserzeugungseinheit
- 24: Kühlluftschlauch
- 25: Regelvorrichtung
- 26: Ausströmöffnungen
- 27: Einströmöffnungen
- 28: Kühlvorrichtung
- 29: zentraler Lüfter

## Patentansprüche

1. Einschub (1) für ein Serverrack (19), welcher Wärme erzeugende Einheiten (10) aufweist und welcher zumindest ein Modul (6) mit einem Anschluss (9) zum Anschließen eines oder mehrerer Kühlluftschläuche (24) an seiner Rückseite (2) aufweist.

2. Einschub (1) für ein Serverrack (19) nach Anspruch 1,
**dadurch gekennzeichnet, dass**
der Einschub (1) ein Kühlkanalsystem (12) aufweist, wobei das Modul (6) mit dem Kühlkanalsystem (12) gekoppelt ist und das Kühlkanalsystem (12) Kühlluft zu den Wärme erzeugenden Einheiten führt.

3. Einschub (1) für ein Serverrack (19) nach Anspruch 1 oder 2,
**dadurch gekennzeichnet, dass**
Luft, welche sich durch die Wärme erzeugenden Einheiten (10) erwärmt, über die Rückseite (2) des Einschubs (1) aus dem Einschub (1) abgeführt wird.

4. Einschub (1) für ein Serverrack (19) nach einem der vorhergehenden Ansprüche,
**dadurch gekennzeichnet, dass**
das Modul (6) eine Drosselvorrichtung (8) zur Einstellung des Luftdrucks der zugeführten Luft aufweist.

5. Einschub (1) für ein Serverrack (19) nach einem der vorhergehenden Ansprüche,
**dadurch gekennzeichnet, dass**
der Einschub (1) an seiner Vorderseite (11) Hotplug-fähige Einheiten aufweist.

6. Anordnung mit einem Einschub (1) für ein Serverrack (19) nach einem der Ansprüche 1 bis 5 und einer Kühlvorrichtung (28) für das Serverrack (19), welche eine Kühleinheit (22) aufweist, wobei an die Kühlvorrichtung (28) ein oder mehrere Kühlluftschläuche (24) angeschlossen sind, welche kühle Luft von der Kühleinheit (22) aus der Kühlvorrichtung (28) herausleiten können.

7. Anordnung nach Anspruch 6,
**dadurch gekennzeichnet, dass**
der Einschub (1) in einem Serverrack (19) angeordnet ist.

8. Anordnung nach Anspruch 6,
**dadurch gekennzeichnet, dass**
die Kühlvorrichtung (28) als Kühleinschub (20) für das Serverrack (19) ausgebildet ist.

9. Anordnung nach Anspruch 7,
**dadurch gekennzeichnet, dass**
die Kühlvorrichtung (28) außerhalb des Serverracks (19) angeordnet ist.

10. Anordnung nach einem der vorhergehenden Ansprüche 7 bis 9,
**dadurch gekennzeichnet, dass**
die Kühleinheit (22) eine Regelvorrichtung aufweist.

11. Einschub (1) für ein Serverrack (19), welcher Wärme erzeugende Einheiten (10) aufweist sowie zumindest einen Luftzuführungsadapter (3) an seiner Rückseite (2), wobei in den Luftzuführungsadapter (3) entweder ein Modul (6) mit einem Anschluss (9) zum Anschließen eines oder mehrerer Kühlluftschläuche (24) oder ein Lüftermodul (17) einsetzbar ist.

12. Einschub (1) nach dem vorhergehenden Anspruch,
**dadurch gekennzeichnet, dass**
der Einschub (1) ein Kühlkanalsystem (12) aufweist, wobei der Luftzuführungsadapter (3) mit dem Kühlkanalsystem (12) gekoppelt ist und das Kühlkanalsystem (12) Kühlluft zu den Wärme erzeugenden Einheiten führt.

13. Einschub (1) für ein Serverrack (19) nach einem der vorhergehenden Ansprüche 11 oder 12,
**dadurch gekennzeichnet, dass**
Luft, welche sich durch die Wärme erzeugenden Einheiten (10) erwärmt, über die Rückseite (2) des Einschubs (1) abgeführt wird.

14. Einschub (1) für ein Serverrack (19) nach einem der vorhergehenden Ansprüche 11 bis 13,
**dadurch gekennzeichnet, dass**
der Luftzuführungsadapter (3) eine Drosselvorrichtung (8) zur Einstellung des Luftdrucks der zugeführten Luft aufweist.

15. Einschub (1) für ein Serverrack (19) nach einem der vorhergehenden Ansprüche 11 bis 14,
**dadurch gekennzeichnet, dass**
der Einschub (1) an seiner Vorderseite (11) Hotplug-fähige Einheiten aufweist.

16. Anordnung mit einem Einschub (1) für ein Serverrack (19) nach einem der Ansprüche 11 bis 15 und einer Kühlvorrichtung (28) für ein Serverrack (19), welche eine Kühleinheit (22) aufweist, wobei an die Kühlvorrichtung (28) ein oder mehrere Kühlluftschläuche (24) angeschlossen sind, welche kühle Luft von der Kühleinheit (22) aus der Kühlvorrichtung (28) herausleiten können.

17. Anordnung nach Anspruch 16,
**dadurch gekennzeichnet, dass**
der Einschub (1) in einem Serverrack (19) angeordnet ist.

18. Anordnung nach Anspruch 16,
**dadurch gekennzeichnet, dass**
die Kühlvorrichtung (28) als Kühleinschub (20) für das Serverrack (19) ausgebildet ist.

19. Anordnung nach Anspruch 17,
**dadurch gekennzeichnet, dass**
die Kühlvorrichtung (28) außerhalb des Serverracks (19) angeordnet ist.

20. Anordnung nach einem der vorhergehenden Ansprüche 17 bis 19,
**dadurch gekennzeichnet, dass**
die Kühleinheit (22) eine Regelvorrichtung aufweist.
